# EUROPÄISCHE PATENTSCHRIFT

(11) **EP 3 140 850 B1**
(45) Veröffentlichungstag und Bekanntmachung des Hinweises auf die Patenterteilung: **16.10.2019**
(21) Anmeldenummer: 14723419.9
(22) Anmeldetag: 09.05.2014
(51) Int. Cl.: H01J 37/32, H01L 21/687

(54) **VERFAHREN UND VORRICHTUNG ZUR PLASMABEHANDLUNG VON SUBSTRATEN**
METHOD AND APPARATUS FOR PLASMA TREATMENT OF SUBSTRATES
PROCEDE ET APPAREIL DE TRAITEMENT DES SUBSTRATES PAR PLASMA

(43) Veröffentlichungstag der Anmeldung: 15.03.2017
(73) Patentinhaber: Ev Group E. Thallner GmbH, 4782 St. Florian am Inn (AT)
(72) Erfinder: GLINSNER, Thomas, A-4782 St. Florian am Inn (AT); FLÖTGEN, Christoph, A-4782 St. Florian am Inn (AT); BERNAUER, Johann, A-4776 Diersbach (AT); WAGENLEITNER, Thomas, A-4971 Aurolzmünster (AT); WIESER, Thomas, 84375 Kirchdorf (DE); SCHMID, Florian, A-4910 Ried im Innkreis (AT); PLACH, Thomas, A-4651 Stadl-Paura (AT); ANZENGRUBER, Roman, A-4752 Riedau (AT); NONES, Alexander, A-4982 Obernberg am Inn (AT); KRIEBISCH, Uwe, A-4782 St. Florian am Inn (AT)
(74) Vertreter: Schneider, Sascha
(86) Internationale Anmeldenummer: PCT/EP2014/059524
(87) Internationale Veröffentlichungsnummer: WO 2015/169385

(56) Entgegenhaltungen:
- JP-A- S6 012 734
- JP-A- H04 317 325
- JP-A- 2002 009 043
- US-A1- 2008 135 177
- US-A1- 2009 250 443

## Beschreibung

Die vorliegende Erfindung betrifft eine Vorrichtung gemäß Patentanspruch 1 sowie ein korrespondierendes Verfahren gemäß Patentanspruch 7.

Viele Halbleiterherstellungsprozesse beinhalten einen oder mehrere Plasmabehandlungsschritte. Das Plasma kann z.B. für das Beschichten eines Substrats, für die Abscheidung von Halbleiterschichten, für das Ätzen eines Substrats, für eine Plasmaaktivierung oder für die Erstellung eines Ionen-Reservoirs genutzt werden. Dabei werden Gase wie z.B. Siliziumwasserstoff (SiH₄), Helium (He), Argon (Ar), Wasserstoff (H₂), und/oder Stickstofftrifluorid (NF₃) in die Plasmakammer geleitet. SiH₄ oder H₂ werden z.B. bei der Abscheidung von Halbleiterschichten und NF₃ wird bei der Plasmaätzung von Halbleiterschichten verwendet. Wird eine Mischung aus Edelgas und einem reaktivem Gas verwendet, kann die Schichtzusammensetzung durch die Einstellung der

Gasmischungsverhältnisse gesteuert werden. So können nicht nur Metalle, sondern auch Oxide, Nitride und Carbide abgeschieden werden. Arbeitsgas bzw. Auswahl des Gasgemisches, Gasdurchfluss und Druck haben einen Einfluss auf das erzeugte Plasma. Atmosphärendruckplasma, Niederdruckplasma oder Hochdruckplasma sind Anwendungsbeispiele. Atmosphärendruckplasmen benötigen im Gegensatz zum Niederdruck- oder Hochdruckplasma kein Reaktionsgefäß, das für die Aufrechterhaltung eines zum Atmosphärendruck unterschiedlichen Druckniveaus oder abweichender Gasatmosphären sorgt. Plasmakammern können gepulst oder kontinuierlich betrieben werden, beispielsweise mit Plasmaprozessen basierend auf Hochfrequenzentladung, Mikrowellenentladung, Gleichstromentladung, sowie Gleichstrom- und/oder Hochfrequenzmagnetronzerstäubung.

Zur Erzeugung von Plasmen gibt es sehr unterschiedliche Methoden, die sich hinsichtlich der Art der Energieeinkopplung deutlich unterscheiden. Durch Anlegen einer Gleichspannung kann eine DC-Entladung erzeugt werden. Kapazitiv gekoppelte MHz-Entladungen (CCP capacitively coupled plasma) werden für das Plasmaätzen und die Plasmabeschichtung eingesetzt. Es können leitende und auch isolierende Substrate mit CCP-Plasmen behandelt werden. Ionenflüsse und Plasmadichte können getrennt voneinander über die Verwendung von mehreren Frequenzen gesteuert werden. Bei einer induktiv gekoppelten Entladung (ICP inductively coupled plasma) wird die Plasmadichte noch weiter erhöht, da das Plasma als Sekundärwicklung eines Transformators fungiert. Die Kopplung erfolgt über eine dielektrische Elektrode was den Nachteil hat, dass eine metallische Beschichtung dieser Elektrode die Einkopplung wieder behindern kann.

Das Substrat ist auf eine Halterung in der Reaktionskammer, bevorzugt einer Plasmakammer, befestigt. Dabei wird eine Hochfrequenzspannung an die Halterung des (Halbleiter-)Substrats angelegt, um die reaktiven Ionen aus dem Plasma auf die zu behandelnde Oberfläche zu richten. Die Hochfrequenzspannung wird mittels der Halterung an dem Substrat selbst angelegt.

Mechanische Klemmvorrichtungen wie beispielsweise 3-Punkt-Aufhängungen werden eingesetzt, verursachen aber durchhängende Substrate, Abrieb und schlechten Wärmekontakt. Das Substrat wird mit Hilfe von, im Probenhalter befindlichen Stiften (Pins) angehoben, sodass ein, insbesondere als Roboterarm ausgebildeter, Robotergreifer (Paddle) unterhalb oder seitlich des Wafers fahren kann und diesen mit einer Aufwärtsbewegung von den Stiften entnimmt. Ein Nachteil ist, dass sich dünne Wafer stark biegen und dadurch kommt es auch zu einer ungenaueren Positionierung des Substrats auf den Stiften. Das elektrostatische Halten ist eine gute Alternative. Durch eine elektrische Spannung zwischen den Probenhalter-Elektroden kann das Substrat festgehalten werden. Elektrostatische Wafer-Haltevorrichtungen sind Teil der Plasmakammer und werden als untere Elektrode zur Plasmaerzeugung eingesetzt. Die Elektrode ist dabei von der Kammerwand elektrisch isoliert. In Ausführungen wo eine innere runde Elektrode und mehrere äußere Ringförmige-Elektroden verwendet werden, sind die einzelnen Ring-Elektroden gegenseitig voneinander isoliert. Elektrostatische Wafer-Haltevorrichtung sind beispielsweise in der US 2002/0159216 A1 sowie der EP 0473930 A1 gezeigt. Aus JP S60 12734 A ist eine unterteilte Elektrode bekannt, deren Mittelteil als Substratauflage dient.

Wafer-Haltevorrichtungen haben, um einen Wafer auf der Halterung aufzunehmen und abzulegen oder einen abgelegten Wafer von der Halterung wegzuheben, in der Halterung einen Hebemechanismus mit Ladestiften. Ein Hebemechanismus ist in der WO 03/038891 A1 in einem Teil der zweiten Elektrode integriert oder in US 2012/0003836 A1 im Substrathalter integriert und kann mittels eines Steuerungsnetzwerkes betrieben werden.

Aufbauten mit Ladestiften als Probenaufnahme haben folgendes Problem: durch die Ladestifte kommt es zu Inhomogenität des Plasmafeldes, was zu Spannungsspitzen während des Prozesses an den notwendigen Aussparungen führt.

Aufgabe der vorliegenden Erfindung ist es daher, ein Verfahren und eine Vorrichtung bereitzustellen, die für die Erzeugung eines homogenen Plasmas mit einem einheitlichen Profil, insbesondere über die gesamte Substratoberfläche, sorgt.

Diese Aufgabe wird mit den Merkmalen der Patentansprüche 1 und 7 gelöst.

Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Die Grundidee der vorliegenden Erfindung ist es, mindestens eine der beiden gegenüberliegenden Elektroden, insbesondere die in der Plasmakammer untere und/oder zur Aufnahme des Substrats dienende, zweiteilig beziehungsweise aus zwei Elektrodeneinheiten auszubilden.

Die Erfindung betrifft mit anderen Worten eine Anlage und eine Methode, um mit einer zweiteiligen Elektrode für Plasmakammern eine optimale Feldhomogenität zu generieren. Eine, insbesondere kreisförmige SubstratAufnahme ist in der unteren Elektrode integriert wobei die untere Elektrode einen äußeren Umfang (äußere Elektrodeneinheit) und einen inneren Bereich (innere Elektrodeneinheit) besitzt. Die innere Elektrode ist bevorzugt gegenüber der äußeren beweglich und dient gleichzeitig zum Halten von Substraten in der Plasmakammer.

Gemäß einer bevorzugten Ausführungsform der angegebenen Erfindung:
1) dient die innere Elektrode der Probenaufnahme und -entnahme (Wafer-Haltevorrichtung),
2) wird ohne Ladestifte Beladen und Entladen, und
3) fährt nach dem Beladen die innere Elektrodeneinheit in eine korrespondierende Ausnehmung der äußeren Elektrodeneinheit, wobei sich insbesondere eine geschlossene, ebene und/oder kontaktgebende Fläche, insbesondere mit gleichem Potential, ergibt.

Die bewegliche innere Elektrodeneinheit ersetzt insbesondere die Ladestifte zum Be- und Entladen der Substrate, so dass auf diese erfindungsgemäß verzichtet werden kann. Dieser Aufbau ermöglicht ein homogeneres Plasma im Vergleich zu Aufbauten mit Ladestiften als Probenaufnahme. Durch die Ladestifte kommt es zu einer Inhomogenität des Plasmafeldes, was zu Spannungsspitzen während des Prozesses an den entsprechenden Aussparungen führt.

Durch eine erfindungsgemäß realisierbare vollflächige Kontaktfläche der inneren und äußeren Elektrodeneinheit mit einer Seitenfläche des Substrats treten diese Feldverschiebungen nicht auf und es wird ein homogeneres Plasma erzeugt.

Außerdem entfällt das zeitaufwendige Einstellen der Ladestifte, was durch die mechanische Konstruktion der inneren Elektrodeneinheit zur äußeren Elektrodeneinheit ersetzt wird und zu einem geringeren Zeitaufwand im Vergleich zu herkömmlichen Designs führt.

Ein weiterer Vorteil ergibt sich durch die flächige Auflage bei der Handhabung von dünnen Substraten, die sich mit dem Ladestiftdesign durch deren Durchbiegung nicht handhaben lassen. Die Größe der inneren Elektrodeneinheit ist anpassbar und damit für verschiedene Substrattypen geeignet.

Die vorliegende Erfindung betrifft demnach insbesondere eine zweiteilige Elektrode für Plasmakammern mit optimaler elektrischer Feldhomogenität. Die Plasmakammer weist in einer ersten erfindungsgemäßen Ausführungsform eine RF-Elektrode (zweite, insbesondere obere, Elektrode) und eine Gegenelektrode (erste, insbesondere zweiteilige, Elektrode) mit einem Substrathalter zur Aufnahme eines Substrats auf. Zwischen der RF-Elektrode und der Gegenelektrode wird insbesondere ein Hochfrequenzwechselfeld zur Erzeugung des Plasmas generiert. In einer zweiten, bevorzugten Ausführungsform weist die Plasmakammer insbesondere eine RF-Elektrode (zweite, insbesondere obere, Elektrode) und eine RF-Gegenelektrode (erste, insbesondere zweiteilige, Elektrode) mit einem Substrathalter zur Aufnahme eines Substrats auf. Gegenpol ist in dieser Ausführungsform das Gehäuse. Vorzugsweise wird das Gehäuse geerdet.
Ein Substrat, bevorzugt ein Wafer, wird zwischen der ersten und der zweiten Elektrode positioniert. Die erste und zweite Elektrode sind an gegenüberliegenden Seiten der Plasmakammer angeordnet und werden bevorzugt als untere und obere Elektrode bezeichnet. Bei der erfindungsgemäßen Ausführungsform besteht eine der zwei Elektroden, bevorzugt die untere Elektrode, aus zwei Baugruppen, insbesondere einer inneren Elektrodeneinheit und einer äußeren Elektrodeneinheit.

Die innere Elektrodeneinheit dient der Substrataufnahme und Substratentnahme für die zu behandelnden Substrate (Wafer, Dünnschicht Substrate, etc.).

Der Substrathalter (erste Elektrode) ist insbesondere so konstruiert, dass bei der Beladung der ersten Elektrode mit dem Substrat die innere Elektrodeneinheit (insbesondere als Probenhalter ausgebildet) nach oben gefahren wird und ein Roboterarm das Substrat auf der inneren Elektrodeneinheit ablegen kann. Der Roboterarm (Paddle) verfügt insbesondere über eine entsprechende Aussparung zur Aufnahme des Substrats.

Die innere Elektrodeneinheit wird insbesondere in einer Z-Richtung bewegt, mit Vorzug zwischen 0 und 50 mm nach oben, mit größerem Vorzug zwischen 2 und 25 mm, mit größtem Vorzug zwischen 2 und 10 mm nach oben. Der Nullpunkt in Z-Richtung ist die Plasmabeaufschlagungsstellung, wo die Auflageflächen der inneren und äußeren Elektrodeneinheiten in gleicher Höhe fluchten, also eine, insbesondere vollständig geschlossene, vorzugsweise ein konstantes Potential aufweisende, Auflageebene E bilden. Der Substrathalter ist mit Vorzug so gebaut, dass nach dem Beladen die innere Elektrode in den Teil der äußeren Elektrode fährt, wobei eine geschlossene, ebene und/oder kontaktgebende Fläche, insbesondere mit gleichem Potential, gebildet wird.

Bevorzugt wird die Elektrodeneinheit als Probenhalter/Substrathalter ausgebildet. Der Substrathalter und/oder der Probenhalter können Fixierelemente zur Fixierung der Substrate besitzen. Bei den Fixierelementen kann es sich um mechanische Klemmen und/oder adhäsive, insbesondere schaltbare, Oberflächen und/oder Vakuumbahnen, und/oder Elektroden als Teil einer elektrostatischen Vorrichtung und/oder magnetische Vorrichtungen, insbesondere Permanentmagnete oder Elektromagnete, handeln. Verfügen Substrathalter und Probenhalter über Fixierelemente, können die Fixierelemente unabhängig voneinander geschalten werden. Dadurch wird es erfindungsgemäß ermöglicht, ein Substrat vom Substrathalter zu lösen, während sich der zentrisch gelagerte, innere Probenhalter bewegen kann und dabei gleichzeitig die Fixierung des Substrats aufrechterhält.

Beim Entladevorgang wird die innere Elektrodeneinheit entsprechend angehoben, damit das Substrat nach der Plasmabehandlung mit dem automatischen Robotergreifer entnommen werden kann.

Als Substrat ist erfindungsgemäß insbesondere ein Produktsubstrat, bevorzugt ein Halbleiterwafer verwendet. Die Substrate können jede beliebige Form besitzen, sind aber bevorzugt kreisrund. Die Durchmesser der Halbleitersubstrate entsprechen mit Vorzug den, in der Halbleiterindustrie üblichen Durchmessern von 2 Zoll, 4 Zoll, 6 Zoll, 8 Zoll, 12 Zoll oder 18 Zoll (5.08 cm, 10.16 cm, 15.24 cm, 20.32 cm, 30.48 cm oder 45.72 cm), können aber auch von diesen abweichen je nach Bedarf. Substrate bestehen bevorzugt aus Materialien und/oder Legierungen wie z.B. Silizium (Si), Siliziumoxid (SiO₂), Siliziumnitrid (Si₃N₄), Aluminium (Al), Wolfram (W) und Titan (Ti). Die erfindungsgemäße Ausführungsform kann grundsätzlich jedes Substrat, insbesondere unabhängig von dessen Durchmesser, handhaben.

Ein, insbesondere eigenständiger, erfindungsgemäßer Aspekt besteht insbesondere darin, dass die innere Elektrodeneinheit gleichzeitig als Substrataufnahme dient und beweglich ist und somit ein einfaches Beladen und Entladen der Probe ohne Ladestifte ermöglicht wird. Die Substrataufnahme dient zur Aufnahme eines flächigen Substrats oder Substratstapels, oder einer Vielzahl von elektronischen Bauelementgruppen, insbesondere Wafern.

Ein weiterer, insbesondere eigenständiger erfindungsgemäßer Aspekt besteht darin, dass die Auflageflächen der inneren und äußeren Elektrode in gleicher Höhe anordenbar bzw. ausrichtbar sind und dadurch in der Plasmabeaufschlagungsstellung eine homogene erste Elektrode bilden. Das Substrat liegt insbesondere vollflächig auf der inneren und der äußeren Elektrodeneinheit auf und wird durch Schwerkraft und durch einen Fokusring auf der ersten, insbesondere unteren, Elektrode gehalten. Eine weitere bzw. zusätzliche Möglichkeit der Fixierung von Substraten am Probenhalter erfolgt mit Hilfe von Vakuum bzw. Unterdruck. Durch eine vollflächige Kontaktfläche der inneren und äußeren Elektrode treten Feldverschiebungen nicht auf und es wird ein homogeneres Plasma erzeugt.

Die, insbesondere als Plasmaelektrode ausgebildete, zweite Elektrode weist insbesondere einen Träger- bzw. ein Außenteil aus Materialien wie Keramik, Glas, Silizium oder einem mineralisch-keramischen Verbundwerkstoff auf, sowie einen Elektrodenkopf aus einem leitfähigen Material.

Die erste, insbesondere zweiteilige, Elektrode besteht bevorzugt aus Materialien und/oder Legierungen aus Wolfram (W), Kupfer (Cu), Aluminium (Al), Platin (Pt), Chrom (Cr), Nickel (Ni), Gold (Au), Titan (Ti), und/oder Edelstahl.

Andere Komponenten der Vorrichtung bestehen bevorzugt aus Graphit oder Siliziumcarbid. Bei Bedarf werden unterschiedliche Trägermaterialien und/oder Elektrodenmaterialien eingesetzt, da die elektrische Eigenschaft der eingesetzten Materialien einen Einfluss auf die Entladung ausüben kann. Bei einer Beschichtung der Elektrode kann, abhängig vom Elektrodenmaterial, die Schichtdicke einen Einfluss auf die Entladung ausüben. Die Schichtdicke beträgt mit Vorzug zwischen 0,1 und 300 µm, mit größerem Vorzug zwischen 0,1 und 200 µm, mit größtem Vorzug zwischen 0,1 und 100 µm. Je nach Anwendung kann auch, unabhängig von der Art des verwendeten Metalls, die Elektrode mit einer dielektrischen Schutzschicht aus z.B. Aluminiumoxid (Al₂O₃)-Keramik beschichtet werden.

Generatoren zum Betreiben und/oder Ansteuern der Elektroden für LF (low frequency), RF (radio frequency) und MW (microwave) werden bevorzugt mit folgenden Frequenzen eingesetzt: LF-Generator mit Frequenzen zwischen 20 und 800 kHz, bevorzugt mit Frequenzen zwischen 40 kHz und 400 kHz, und Leistungsstärken zwischen 1 und 100000 Watt, mit Vorzug zwischen 20 und 2500 Watt; RF-Generator mit Frequenzen zwischen 3 und 300 MHz, bevorzugt mit Frequenzen zwischen 3 und 30 MHz, und Leistungsstärken zwischen 1 und 100000 Watt, mit Vorzug zwischen 20 und 1000 Watt; MW-Generator mit Frequenzen zwischen 300 MHz und 300 GHz, bevorzugt zwischen 300 MHz und 3 GHz, und Leistungsstärken zwischen 10 und 1200 Watt oder höher. Frequenzen von 40 kHz sind nur bedingt geeignet für Halbleiter Front-End Prozesse aber gut geeignet für Back-End Prozesse. Frequenzen von 13,56 MHz sind für Front-End und für Back-End Prozesse geeignet. Bei niedrigen Frequenzen von 40 kHz ist die Plasmadichte vergleichsweise gering und somit auch der Anteil an erzeugten Radikalen geringer, was zu einer niedrigeren Abtragungsrate (z.B. beim Trockenätzen) führt. Beide Frequenzbereiche können je nach Bedarf für beide Elektroden zum Einsatz kommen. Jede Elektrode ist vorzugsweise an eine eigene Stromversorgung in Form eines Generators für die erste Elektrode und eines, insbesondere separat hierzu steuerbaren, zweiten Generators für die zweite Elektrode angeschlossen. Durch die Auswahl der äußeren elektrischen Parameter wie Spannung, Strom und Frequenz kann die Plasma-Entladung je nach Bedarf und Anwendung gesteuert werden. Somit ist es möglich, durch individuell angepasste Betriebsbedingungen die Selektivität plasmachemischer Prozesse zu erhöhen.

Der, insbesondere dielektrische, Fokusring besteht bevorzugt aus dem gleichen Material wie das Substrat. Bevorzugte dielektrische Materialien sind Siliziumdioxid (SiO₂), Siliziumnitrid (Si₃N₄), Aluminiumoxid (Al₂O₃), Siliziumkarbid (SiC) und Siliziumkarbonitrid (SiCN). Der Fokusring ist insbesondere an der Oberseite der äußeren Elektrode, also auf der Auflageebene, angebracht. Materialauswahl und Positionierung auf der ersten Elektrode sollen erfindungsgemäß so gewählt werden, dass möglichst kleine oder keine Potentialdifferenzen zwischen dem Fokusring und dem Substrat auftreten. Hierdurch wird die Homogenität am Rand des Substrats positiv beeinflusst.

Die erfindungsgemäße Ausführungsform befindet sich mit Vorzug in einer hermetisch versigelbaren, über das Abheben eines Deckels zugänglichen, insbesondere evakuierbaren Kammer, mit größtem Vorzug in einer Plasmakammer. Neben Edelstahlkammern können Quarzglaskammern verwendet werden.

Die Plasmakammer wird zur Plasmabeaufschlagung insbesondere auf einen Druck von weniger als 1 bar, mit Vorzug weniger als 1 mbar, mit größerem Vorzug weniger als 0.1 mbar, mit größtem Vorzug auf weniger als 0.01 mbar mit allergrößtem Vorzug auf weniger als 0.0001 mbar evakuiert. Die Plasmakammer kann mit Vorzug auch auf Überdruck beansprucht werden. Der maximale Druck ist dabei insbesondere größer 1 bar, mit Vorzug größer als 1.5 bar, mit größerem Vorzug größer als 2 bar, mit größtem Vorzug größer als 5 bar, mit allergrößtem Vorzug größer als 10 bar.

Ein Ionenstrommesssensor kann zur Prozesskontrolle in die Plasmakammer integriert werden. Die zweiteilige Elektrode kann für unterschiedliche Betriebsarten der Plasmakammer wie z.B. PE (Plasma-Etch) Betrieb oder RIE (Reactive Ion Etching) Betrieb eingesetzt werden. In der Halbleitertechnik wird ein RIE-Betrieb zur Erzeugung von Strukturen in Wafern verwendet da das gerichtete Plasma senkrecht auf das Substrat trifft.

Je nach verwendetem Plasmagas und zugeführter Energie werden im Plasmastrahl Temperaturen von 400 bis 50.000 K erreicht. Auf Grund der Prozesse in der Plasmakammer kann es zu einer erheblichen Temperaturerhöhung kommen, welche zu einer Aufheizung des Substrats führt. Die Kühlung bzw. Aufheizung des Substrats erfolgt über eine thermische Kopplung an die Substrataufnahme, die insbesondere Kühl- und/oder Heizelemente besitzt. Um eine gleichmäßige thermische Kopplung zwischen Substrat und Substrataufnahme zu gewährleisten, ist ein ausreichender und ganzflächiger thermischer Kontakt des Substrats mit der Substrataufnahme (erste Elektrode) erfindungsgemäß während der Plasmabehandlung realisierbar. Ein Kühlmittel z.B. flüssiges Helium kann auf der Unterseite des Wafers zirkuliert werden um den Wafer zu kühlen. Anstatt einer Kühlleitung können auch sonstige Kühlelemente vorgesehen werden wie z.B. ein Peltierelement. Das Substrat kann insbesondere aufgeheizt werden durch ein Heizsystem, welches insbesondere in der ersten, zweiteiligen Elektrode integriert angeordnet ist.

Bei temperaturabhängigen Reaktionen wird das Plasma insbesondere für das Ätzen eines Substrats verwendet. Hierbei ist es wichtig, eine homogene konstante Temperatur auf der zu ätzenden Oberfläche des Substrats zu halten, da die Ätzreaktion temperaturabhängig ist. Vorteilhafterweise werden Temperaturfühler bzw. Thermoelemente oder Temperatur-Sensoren in die Substrathalterung integriert. In einer weiteren Ausführung enthält die Substrathalterung bzw. die zweiteilige Elektrode Gas Einlassleitungen oder Öffnungen bzw. Auslassleitungen oder Öffnungen.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:

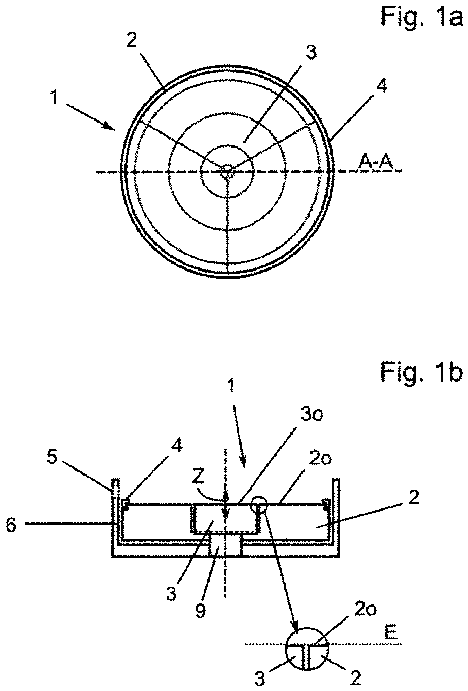

- Figur 1a: eine Aufsicht auf eine Ausführungsform der erfindungsgemäßen Vorrichtung,

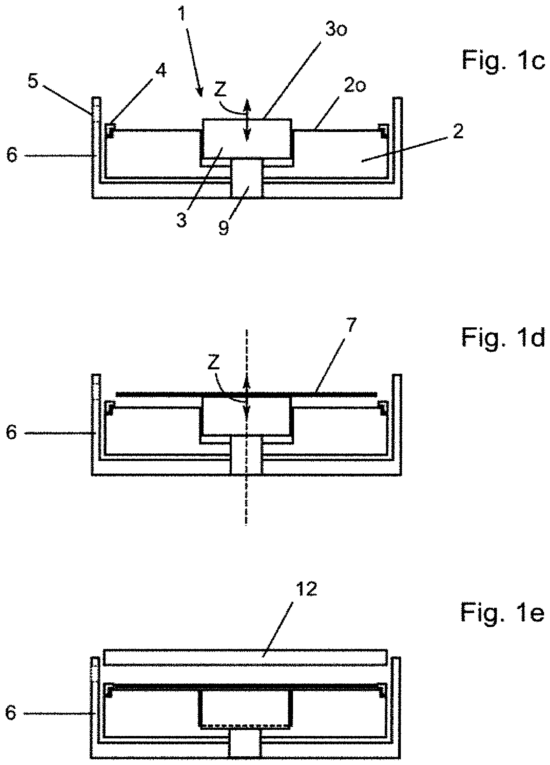

- Figur 1: b eine Querschnittsansicht der Ausführungsform gemäß Figur 1a,
- Figur 1c: eine Querschnittsansicht der Ausführungsform gemäß Figur 1a in einem ersten erfindungsgemäßen Verfahrensschritt,
- Figur 1: d eine Querschnittsansicht der Ausführungsform gemäß Figur 1a in einem zweiten erfindungsgemäßen Verfahrensschritt,
- Figur 1e: eine Querschnittsansicht der Ausführungsform gemäß Figur 1a in einem dritten erfindungsgemäßen Verfahrensschritt,
- Figur 2a: eine Aufsicht auf die Ausführungsform gemäß Figur 1a mit einem Robotergreifer,
- Figur 2b: eine Aufsicht auf die Ausführungsform gemäß Figur 1a mit einem alternativen Robotergreifer,
- Figur 2c: eine Aufsicht auf einer weiteren Ausführungsform der erfindungsgemäßen Vorrichtung, und
- Figur 3: eine detaillierte Querschnittsansicht einer weiteren Ausführungsform der erfindungsgemäßen Vorrichtung.

In den Figuren sind gleiche Bauteile und Bauteile mit der gleichen Funktion mit den gleichen Bezugszeichen gekennzeichnet.

Figur 1a zeigt eine Draufsicht auf eine, insbesondere untere, erste Elektrode 1 in einer Plasmakammer 6, insbesondere mit einer integrierten Substrat-Haltevorrichtung gemäß einem Ausführungsbeispiel der Erfindung. Die Halterung eines Substrats 7 erfolgt insbesondere durch Vakuumbahnen und/oder durch einen Fokusring 4, 4'. Die erste Elektrode 1 weist eine als Ringelektrode ausgebildete äußere Elektrodeneinheit 2 und eine innere Elektrodeneinheit 3 auf. Die innere Elektrodeneinheit 3 wird von der äußeren Elektrodeneinheit 2 seitlich begrenzt und umschlossen. Das Substrat 7 wird außen durch den das Substrat 7 umgebenden, insbesondere umschließenden, Fokusring 4, 4' gehalten.

Figur 1b zeigt einen Querschnitt durch die erste Elektrode 1 und die Plasmakammer 6. Die zweiteilige bzw. aus der inneren Elektrodeneinheit 3 und der äußeren Elektrodeneinheit 2 gebildete erste Elektrode 1 dient als Halterung für das Substrat 7, insbesondere mit einer ebenen Oberfläche 2o der äußeren Elektrodeneinheit 2. Die innere Elektrodeneinheit 3 dient zum Beladen und Entladen des Substrats 7, insbesondere mit einer, vorzugsweise Vakuumbahnen aufweisenden, ebenen Oberfläche 3o.

Die Oberflächen 2o, 3o bilden in einer Plasmabeaufschlagungsposition gemäß Figur 1b eine gemeinsame, insbesondere kontaktgebende und/oder geschlossene, Auflageebene E.

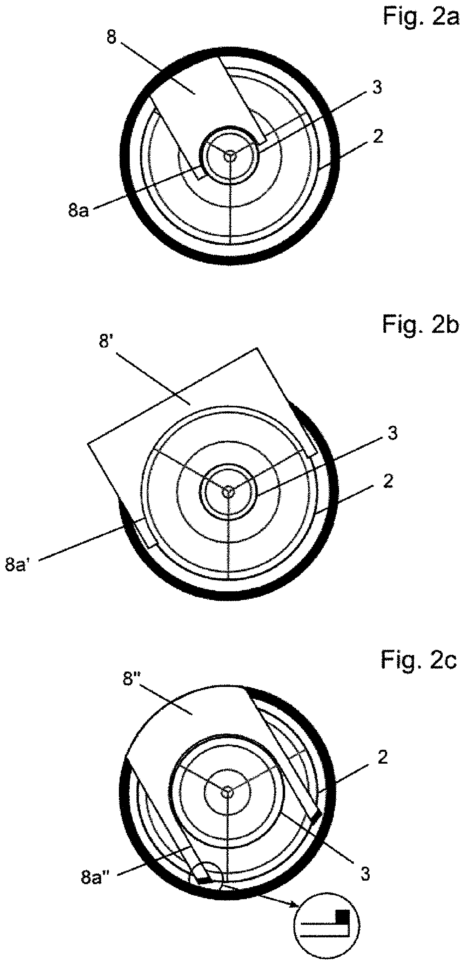

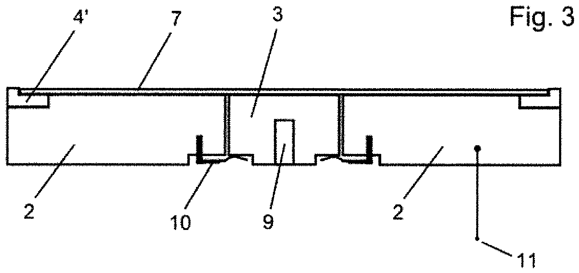

Die Figuren 1b bis 1e zeigen eine erfindungsgemäße Ausführungsform eines erfindungsgemäßen Verfahrensablaufs. Figur 1c zeigt, dass die innere Elektrodeneinheit 3 gegenüber der äußeren Elektrodeneinheit 2 in einer Z-Richtung angehoben wird (Hebemechanismus 9 siehe auch Figur 3) oder aus der Auflageebene E herausfährt (Beladeposition). Die Substrathalterung umfasst einen Hebemechanismus, der mit der inneren Elektrodeneinheit 3 verbunden ist. Eine radial gelagerte Hubwelle des Hebemechanismus 9 hebt die, insbesondere als Probenhalter ausgebildete, innere Elektrodeneinheit 3 in der Z-Richtung senkrecht zur Elektrodenoberfläche 3o. Der Hebemechanismus kann mittels eines Steuerungsnetzwerkes betrieben werden (nicht dargestellt).
Das Substrat 7 wird von einem Handler oder Robotergreifer, insbesondere einem Roboterarm 8 (Figur 2a), 8' (Figur 2b), 8" (Figur 2c) auf der, insbesondere als Probenhalter ausgebildeten, inneren Elektrodeneinheit 3 abgelegt und nach der Plasmabehandlung wieder entnommen. Der/Die Robotergreifer sind stationär oder mobil und erfüllen vorprogrammierte festgelegte Aufgaben. Figuren 2a, 2b und 2c zeigen drei erfindungsgemäße Ausführungsformen des Roboterarms 8, 8', 8". Der Roboterarm 8, 8', 8" fährt durch eine entsprechend ausgeformte Öffnung 5 (siehe Figur 1b) der Plasmakammer 6 zum Beladen oder Entladen des Substrats 7. Der Roboterarm 8, 8', 8" verfügt über eine Aussparung 8a, 8a', 8a" zur Aufnahme des Substrats 7 entsprechend der Substratgröße, wie in den erfindungsgemäßen Ausführungsformen in Figuren 2a, 2b und 2c gezeigt. In der Ausführungsform des Roboterarms 8" gemäß Figur 2c wird die Außenkontur des Substrats 7 durch Klemmelemente umschlossen. Mittels des Roboterarms 8, 8', 8" wird das Substrat 7 auf die innere Elektrodeneinheit 3 abgelegt (siehe Figur 1d). Das Substrat 7 liegt, insbesondere vollflächig, auf den inneren und äußeren Elektrodeneinheiten 2, 3 (Figur 2b), oder nur auf der inneren Elektrodeneinheit 3, die an die Größe des Substrats angepasst werden kann (Figuren 2a und 2c), auf.

In dem, in Figur 1e gezeigten Verfahrensschritt fährt die innere Elektrodeneinheit 3 nach dem Beladen des Substrats 7 in die Plasmabeaufschlagungsposition zurück. Das Substrat 7 wird mittels des Fokusrings 4, 4' und der Schwerkraft gehalten. Dadurch können alle Arten von Substraten 7, insbesondere aus niederohmigen Materialien (Silizium) oder aus höherohmigen Materialien, gehalten werden.

Figur 1b und Figur 3 zeigen zwei unterschiedliche erfindungsgemäße Ausführungsformen des Fokusrings 4, 4'.

Da die innere Elektrodeneinheit 3 und die äußere Elektrodeneinheit 2 zur Plasmabehandlung insbesondere auf ein gleiches Potential gebracht werden, ist eine Isolierung zwischen innere und äußere Elektrode nicht notwendig. Durch das gleiche Potential und das Wegfallen von Störfaktoren (wie z.B. Ladestifte) wird ein homogen über die zu bearbeitende Substratoberfläche verteiltes Potenzial erreicht. Die zweiteilige erste Elektrode 1 zeigt also keine elektrischen Feldspitzen. Die homogene Potentialverteilung führt zu einem homogenen Plasma entlang des gesamten Substrats 7.

Wie in Figur le gezeigt wird eine zweite Elektrode 12 gegenüberliegend zur ersten Elektrode 1 angeordnet, um zwischen den Elektroden 1, 12 ein Plasma auszubilden. Hierzu wird die Plasmakammer 6 geschlossen, um die für das Plasma erforderlichen Bedingungen einstellen zu können.
In einer bevorzugten Ausführungsform wird über einen
Hochfrequenzanschluss 11 an der ersten Elektrode 1, insbesondere an der äußeren Elektrodeneinheit 2, eine Hochfrequenzspannung, insbesondere kapazitiv, gekoppelt. Dabei ist der Kondensator bevorzugt in einer Anpassungseinheit integriert. Somit wird eine ohmsche Ankoppelung durchgeführt, wobei die elektrische Zuleitung zum Generator
(Hochfrequenzanschluss 11) über einen Koppelkondensator mit der Elektrode verbunden ist. Der Koppelkondensator, der zwischen Elektrode und Generator geschalten wird, dient insbesondere als Hochpassfilter um die entsprechenden Gleichstromanteile herauszufiltern, sodass, bevorzugt ausschließlich, der Wechselspannungsanteil an der Elektrode angelegt wird. Insbesondere kann der hochpassgefilterte Spannungsanteil mit einem reinen Gleichspannungsanteil überlagert werden.

Figur 3 zeigt einen detaillierteren Querschnitt einer Ausführungsform der zweiteiligen Elektrode 1. Die elektrische Ankoppelung über den Hochfrequenzanschluss (Rf-Anschluss) 11 und elektrische Kontaktierungselemente 10 zur Kontaktierung der inneren Elektrodeneinheit 3 sind hier dargestellt. Nach dem Beladen des Substrats auf die innere Elektrodeneinheit 3 werden beim Einfahren der inneren Elektrodeneinheit 3 in die äußere Elektrodeneinheit 2 bei Erreichen der Plasmabeaufschlagungsposition Federkontaktelemente 10 kontaktiert.

Das Substrat 7 wird durch Schwerkraft und durch den Fokusring 4, 4' gehalten. Entsprechende Kontaktpunkte der inneren Elektrodeneinheit 3 und der äußeren Elektrodeneinheit 2 sind mittels der Federkontaktelemente 10 verbunden, so dass die äußere und die innere Elektrodeneinheit 2, 3 auf gleiches Potential gebracht sind.

Die zweiteilige Elektrode 1 hat insbesondere mindestens zwei Federkontaktelemente 10, mit Vorzug mehr als zwei, mit größerem Vorzug mehr als drei, mit noch größerem Vorzug mehr als vier, mit größtem Vorzug sechs oder mehr Federkontaktelemente 10. In einer bevorzugten Ausführungsform werden genau sechs Federkontaktelemente 10 verwendet.

In einer alternativen erfindungsgemäßen Ausführungsform werden die Kontaktpunkte der inneren und der äußeren Elektrodeneinheiten 2, 3 mittels Drahtverbindungen elektrisch verbunden. Nach dem Beladen des Substrats 7 auf die innere Elektrodeneinheit 3 werden beim Einfahren der inneren Elektrodeneinheit die offenen Kontaktpunkte kontaktiert. Dies führt zu einer sehr guten Leitfähigkeit zwischen den Elektrodeneinheiten 2, 3. Bevorzugt sind Metallleiterbahnen oder Drahtverbindungen zwischen der inneren und der äußeren Elektrodeneinheit 2, 3 angeordnet. Jede Elektrodeneinheit 2, 3 hat bevorzugt mehrere Kontaktbereiche, insbesondere am Umfang verteilt. Die innere und äußere Elektrodeneinheit stehen jeweils in elektrischer Verbindung mit den Kontaktbereichen.

Die zweiteilige erste Elektrode 1 hat insbesondere mindestens zwei Kontaktbereiche, mit Vorzug mehr als zwei, mit größerem Vorzug mehr als drei, mit noch größerem Vorzug mehr als vier, mit größtem Vorzug sechs oder mehr Kontaktbereiche.

Um eine effektive Kopplung des Hochfrequenzanschlusses 11 mit der Plasma-Kammer zu erreichen, ist die Anpassungseinheit bevorzugt so eingestellt, dass die Impedanz der Plasma-Kammer mit der Impedanz einer RF Koaxialleitung zum Hochfrequenzanschluss 11 übereinstimmt. Gekoppelte Anschlüsse (z.B. Gleichspannungsanschlüsse) und Kondensator-Schaltung (i.e. kapazitive Kopplungsnetzwerke) sind in der Anpassungseinheit integriert und sind somit insbesondere nicht Bestandteil der zweiteiligen ersten Elektrode 1.

### Bezugszeichenliste

- 1: Erste Elektrode
- 2: Äußere Elektrodeneinheit
- 2o: Oberfläche der äußeren Elektrodeneinheit
- 3: Innere Elektrodeneinheit
- 3o: Oberfläche der inneren Elektrodeneinheit
- 4, 4': Fokusring
- 5: Öffnung
- 6: Plasmakammer
- 7: Substrat
- 8, 8', 8": Roboterarme
- 8a, 8a', 8a": Aussparungen
- 9: Hebemechanismus
- 10: Federkontaktelemente
- 11: Hochfrequenzanschluss
- 12: Zweite Elektrode
- E: Auflageebene
- Z: Z-Richtung

## Patentansprüche

1. Vorrichtung zur Beaufschlagung mindestens eines Substrats (7) mit einem Plasma mit einer ersten Elektrode (1) und einer gegenüberliegend dazu anordenbaren zweiten Elektrode (12), die gemeinsam das Plasma zwischen den Elektroden (1, 12) erzeugend ausgebildet sind, wobei mindestens eine der Elektroden (1, 12) aus mindestens einer inneren und einer äußeren Elektrodeneinheit (2, 3) gebildet ist, wobei sich die beiden Elektrodeneinheiten (2, 3) im Betrieb auf dem gleichen Potential befinden, wobei die innere Elektrodeneinheit (3) nach oben fahrbar ist und ein Roboterarm (8,8',8") das Substrat (7) auf der inneren Elektrodeneinheit (3) ablegen kann, wobei die innere Elektrodeneinheit (3) und die äußere Elektrodeneinheit (2) eine gemeinsame Auflageebene (E) ausbildend anordenbar sind, wobei das Substrat (7) insbesondere vollflächig auf der inneren (3) und der äußeren Elektrodeneinheit (2) aufliegt.

2. Vorrichtung nach Anspruch 1, wobei die zwei Elektrodeneinheiten (2, 3) separat ansteuerbar sind.

3. Vorrichtung nach einem der vorhergehenden Ansprüche, wobei die mindestens zwei Elektrodeneinheiten (2, 3) eine innere Elektrodeneinheit (3) und eine äußere, insbesondere die innere Elektrodeneinheit (3) aufnehmende und/oder umgebende, insbesondere umschließende, Elektrodeneinheit (2) aufweisen,

4. Vorrichtung nach einem der vorhergehenden Ansprüche, wobei mindestens eine der Elektrodeneinheiten (2, 3), insbesondere die innere Elektrodeneinheit (3), in einer Z-Richtung, insbesondere relativ zu einer anderen der Elektrodeneinheiten (2, 3), vorzugsweise zu der äußeren Elektrodeneinheit (2), bewegbar ist.

5. Vorrichtung nach Anspruch 1, wobei die gemeinsame Auflageebene als geschlossene und/oder kontaktgebende Fläche, insbesondere mit gleichem Potential, beaufschlagbar ist.

6. Vorrichtung nach einem der vorhergehenden Ansprüche, wobei mindestens eine der Elektrodeneinheiten (2, 3), insbesondere die innere, als Probenhalter zur Aufnahme und/oder Fixierung des Substrats oder der Substrate ausgebildet ist.

7. Verfahren zur Beaufschlagung mindestens eines Substrats (7) mit einem, durch eine erste Elektrode (1) und eine gegenüberliegend zur ersten Elektrode (1) angeordneten zweiten Elektrode (12) erzeugten Plasma, wobei mindestens eine der Elektroden (1, 12) mindestens eine innere und einer äußere Elektrodeneinheit (2, 3) aufweist, wobei die beiden Elektrodeneinheiten (2,3) auf ein gleiches Potential gebracht werden, wobei die innere Elektrodeneinheit (3) nach oben gefahren wird und ein Roboterarm (8,8',8") das Substrat (7) auf der inneren Elektrodeneinheit (3) ablegt, wobei die innere Elektrodeneinheit (3) und die äußere Elektrodeneinheit (2) zur Beaufschlagung mit dem Plasma in einer gemeinsamen Auflageebene angeordnet werden, wobei das Substrat (7) insbesondere vollflächig auf der inneren (3) und der äußeren Elektrodeneinheit (2) aufliegt.

8. Verfahren nach Anspruch 7, wobei die zwei Elektrodeneinheiten (2, 3) separat angesteuert werden.

9. Verfahren nach einem der Ansprüche 7 oder 8, wobei mindestens eine der Elektrodeneinheiten (2, 3), insbesondere die innere Elektrodeneinheit, zur Aufnahme und/oder Fixierung des Substrats oder der Substrate in einer Z-Richtung, insbesondere relativ zu der äußeren Elektrodeneinheit, bewegt wird.

10. Verfahren nach Anspruch 7, wobei die gemeinsame Auflageebene als geschlossene und/oder kontaktgebende Fläche, insbesondere mit gleichem Potential, beaufschlagt wird.

## Claims

1. Device for exposing at least one substrate (7) to a plasma with a first electrode (1) and a second electrode (12) that can be arranged opposite thereto, which electrodes are formed together producing the plasma between the electrodes (1, 12), wherein at least one of the electrodes (1, 12) is formed from at least two electrode units (2, 3), wherein during operation the two electrode units (2,3) are brought to the same potential, wherein the inner electrode unit (3) is movable upwards and a robot arm (8,8',8") can place the substrate (7) on the inner electrode unit (3), wherein the inner electrode unit (3) and the outer electrode unit (2) can be arranged to form a common support plane (E), wherein the substrate (7) lies in particular over the entire surface on the inner (3) and the outer electrode unit (2).

2. Device according to Claim 1, whereby the two electrode units (2, 3) can be controlled separately.

3. Device according to one of the preceding claims, whereby the at least two electrode units (2, 3) have an inner electrode unit (3) and an outer electrode unit (2) that picks up and/or surrounds, in particular encloses, in particular the inner electrode unit (3).

4. Device according to one of the preceding claims, whereby at least one of the electrode units (2, 3), in particular the inner electrode unit (3), can be moved in a Z-direction, in particular relative to another of the electrode units (2, 3), preferably the outer electrode unit (2).

5. Device according to Claim 1, whereby the common support plane can be applied as a closed and/or contact-providing surface, in particular with a uniform potential.

6. Device according to one of the preceding claims, whereby at least one of the electrode units (2, 3), in particular the inner electrode unit, is designed as a sample holder for receiving and/or attaching the substrate or the substrates.

7. Method for exposing at least one substrate (7) to a plasma produced by a first electrode (1) and a second electrode (12) arranged opposite to the first electrode (1), wherein at least one of the electrodes (1, 12) has at least an inner and an outer electrode unit (2, 3), wherein the two electrode units (2,3) are brought to the same potential, wherein the inner electrode unit (3) is moved upwards and a robot arm (8,8',8") places the substrate (7) on the inner electrode unit (3), wherein the inner electrode unit (3) and the outer electrode unit (2) are arranged in a common support plane (E) for exposing to the plasma, wherein the substrate (7) lies in particular over the entire surface on the inner (3) and the outer electrode unit (2).

8. Method according to Claim 7, whereby the two electrode units (2, 3) are controlled separately.

9. Method according to one of Claims 7 or 8, whereby at least one of the electrode units (2, 3), in particular the inner electrode unit, is moved to receive and/or attach the substrate or the substrates in a Z-direction, in particular relative to the outer electrode unit.

10. Method according to Claim 7, whereby the common support plane is applied as a closed and/or contact-providing surface, in particular with a uniform potential.

## Revendications

1. Dispositif pour alimenter au moins un substrat (7) avec un plasma comprenant une première électrode (1) et une seconde électrode (12), pouvant être placée opposée à celle-ci, qui sont conçues produisant conjointement le plasma entre les électrodes (1, 12), dans lequel au moins une des électrodes (1, 12) est formée d'au moins une unité d'électrode intérieure et extérieure (2, 3), dans lequel les deux unités d'électrode (2, 3) se trouvent au même potentiel en fonctionnement, dans lequel l'unité d'électrode intérieure (3) peut être déplacée vers le haut, et un bras de robot (8, 8', 8") peut déposer le substrat (7) sur l'unité d'électrode intérieure (3), dans lequel l'unité d'électrode intérieure (3) et l'unité d'électrode extérieure (2) peuvent être agencées en formant un plan d'appui (E) commun, dans lequel le substrat (7) repose essentiellement par toute sa surface sur l'unité d'électrode intérieure (3) et extérieure (2).

2. Dispositif selon la revendication 1, dans lequel les deux unités d'électrode (2, 3) peuvent être commandées de manière séparée.

3. Dispositif selon l'une des revendications précédentes, dans lequel les au moins deux unités d'électrode (2, 3) présentent une unité d'électrode intérieure (3) et une unité d'électrode extérieure (2) recevant et/ou encerclant, en particulier entourant l'unité d'électrode intérieure (3).

4. Dispositif selon l'une des revendications précédentes, dans lequel au moins une des unités d'électrode (2, 3), en particulier l'unité d'électrode intérieure (3), est mobile dans un sens Z, en particulier par rapport à une autre des unités d'électrode (2, 3), de préférence par rapport à l'unité d'électrode extérieure (2).

5. Dispositif selon la revendication 1, dans lequel le plan d'appui commun peut être alimenté en tant que face fermée et/ou offrant un contact, en particulier avec le même potentiel.

6. Dispositif selon l'une des revendications précédentes, dans lequel au moins une des unités d'électrode (2, 3), en particulier l'unité intérieure, est conçue en tant que support d'échantillon pour recevoir et/ou fixer le ou les substrat(s).

7. Procédé pour alimenter au moins un substrat (7) avec un plasma produit par une première électrode (1) et une seconde électrode (12) placée opposée à la première électrode (1), dans lequel au moins une des électrodes (1, 12) présente au moins une unité d'électrode intérieure et extérieure (2, 3), dans lequel les deux unités d'électrode (2, 3) sont amenées à un même potentiel, dans lequel l'unité d'électrode intérieure (3) est déplacée vers le haut, et un bras de robot (8, 8', 8") dépose le substrat (7) sur l'unité d'électrode intérieure (3), dans lequel l'unité d'électrode intérieure (3) et l'unité d'électrode extérieure (2) sont agencées dans un plan d'appui commun pour l'alimentation avec le plasma, dans lequel le substrat (7) repose essentiellement par toute sa surface sur l'unité d'électrode intérieure (3) et extérieure (2).

8. Procédé selon la revendication 7, dans lequel les deux unités d'électrode (2, 3) peuvent être commandées de manière séparée.

9. Procédé selon la revendication 7 ou 8, dans lequel au moins une des unités d'électrode (2, 3), en particulier l'unité d'électrode intérieure, est déplacée dans un sens Z, en particulier par rapport à l'unité d'électrode extérieure pour recevoir et/ou fixer le ou les substrat(s).

10. Procédé selon la revendication 7, dans lequel le plan d'appui commun est alimenté en tant que face fermée et/ou offrant un contact, en particulier avec le même potentiel.
